# EUROPEAN PATENT APPLICATION

(11) **EP 4 502 754 A1**
(43) Date of publication of application: **05.02.2025**
(21) Application number: 23188993.2
(22) Date of filing: 01.08.2023
(51) Int. Cl.: G05F 1/46, H03F 3/45

(54) **BUFFER CIRCUIT FOR PROVIDING A FLOATING REFERENCE SIGNAL, VOLTAGE GENERATING CIRCUIT AND METHOD FOR PROVIDING A FLOATING REFERENCE SIGNAL**

(71) Applicant: u-blox AG, 8800 Thalwil (CH)
(72) Inventor: Martin, Benjamin, 8800 Thalwil (CH); Baggini, Barbara, 8800 Thalwil (CH); Anagnostopoulos, Dimitrios, 15125 Maroussi (GR); Liakou, Fani, 15125 Maroussi (GR); Blatter, Samuel, 8800 Thalwil (CH)
(74) Representative: Epping - Hermann - Fischer

(57) **Abstract**

In one embodiment a buffer circuit for providing a floating reference signal comprises an operational amplifier comprising a first input, a second input, a third input and an output. The first input represents a non-inverting input and is configured to receive a first input signal. The second input represents another non-inverting input and is configured to receive a second input signal. The third input represents an inverting input. The output forms an output of the buffer circuit. The operational amplifier is configured as a voltage follower. The buffer circuit is configured to provide either the first or the second input signal at its output, such that a lower one of the first and the second input signal is provided as the floating reference signal.

## Description

### Technical field

The present disclosure relates to electronic circuitry, especially to the generation of reference signals. Specifically, the disclosure is directed to a buffer circuit for providing a floating reference signal, a voltage generating circuit and a method for providing a floating reference signal.

### Background

Many circuits, for example, integrated circuits, need reference signals, which are usually generated internally from a source external to the chip. Said source can be realized as supply voltage source. The generated reference signal may represent a reference current or a reference voltage. The reference signal is designed to maintain a constant level over variations in the supply voltage, over a range of temperatures, and variations in the manufacturing process.

Reference signals are often employed for controlling transistors, for example, Metal-oxide semiconductor, MOS-transistors, or bipolar transistors within said circuits. Transistors have a defined operating range which amongst others in the case of MOS transistors is defined by a maximum gate source voltage of the transistors. In circuits using a high-voltage supply, the value of the high voltage on the supply exceeds the operating range, i.e. the gate source voltage, of employed transistors. As a consequence, simple digital circuit elements based on complementary MOS, CMOS, technology, such as inverters, cannot be used to control the gate terminals of switching transistors, where a signal switching from the highest value of the supply voltage, usually called VDD, to the lowest value of the supply voltage, usually called VSS, i.e. zero volt, shall control both the involved p-channel MOS, PMOS, and n-channel MOS, NMOS transistor.

Instead, for these high-voltage circuits, separate signals must be provided to the control inputs, or gate terminals, of NMOS and PMOS transistors. Said signals are level shifted from each other, in order to keep both transistor types within their safe operating range. The signal that controls the PMOS gate, for example, ideally switches from VDD when the transistor is off, to VDD minus the maximum gate source voltage when the transistor is on. For this, a circuit designer must conceptualize a so-called floating reference signal which is used as the "lower" reference to control the PMOS transistor's gate terminal. Said floating reference signal is defined in relation to the supply voltage. For example, it tracks the supply voltage at slightly above VDD minus the maximum gate source voltage. The margin to VDD minus the maximum gate source voltage is typically set to ensure that even over environmental and process variations, the reference signal never goes lower than VDD minus the maximum gate source voltage. The smaller the variation in generation of the floating reference, the closer a voltage value of this signal can be set to VDD minus the maximum gate source voltage.

One common way to derive a highly-accurate reference at VDD minus the maximum gate source voltage is to use a bandgap circuit. Bandgap circuits nominally provide a reference signal that is quite immune to supply voltage and environmental or process variations. Often, such a bandgap circuit is operated on a low-voltage circuit and the output reference signal is X volts above ground potential. This reference voltage is transferred to the high-voltage circuit using a current mirror and matching resistors to form a new reference signal which is at VDD minus k times X volts, where k is some constant. Said reference signal is then buffered by a reference buffer on the VDD, i.e. high-voltage, domain.

The inventors have found that this solution works in principle, but that it suffers from the fact that bandgap circuits are slow to turn on. Bandgaps usually employ very large resistances internally in order to minimize their power consumption. However, large resistors result in a long settling time during power-up. In the case that PMOS transistors in the circuit relying on the reference signal provided by the bandgap need to be held-on during start-up, the state of the art circuit design fails, because it takes some time before the bandgap starts up and provides the reference signal at the required level. Also, if a low-dropout, LDO, circuit is employed as additional power supply to lower the bandgap circuit's power consumption, this LDO needs a reference signal, which normally is provided by a bandgap circuit. This results in a chicken and egg problem at least during power up of the circuit.

An objective could therefore be seen in providing a solution which overcomes the shortcomings of the prior art circuit design. In particular, a solution shall be provided which enables provision of a suitable reference signal for transistors operated in a voltage range exceeding said transistors' operating range as soon as possible in the start-up procedure.

The objective is achieved by the subject-matter of the independent claims. Embodiments and developments are defined in the dependent claims.

The definitions provided above also apply to the following description unless stated otherwise.

### Summary

In one embodiment a buffer circuit for providing a floating reference signal comprises an operational amplifier with a first input, a second input, a third input and an output. The first input represents a non-inverting input, which is configured to receive a first input signal. The second input represents another non-inverting input, which is configured to receive a second input signal. The third input represents an inverting input. The output forms an output of the buffer circuit. The operational amplifier is configured as a voltage follower in that its output is connected to its third input. The buffer circuit is configured to provide either the first or the second input signal at its output, such that a lower one of the first and the second input signal is provided as the floating reference signal.

The floating reference provided by the operational amplifier comprises either the first input signal or the second input signal, depending on which of these input signals is lower at the moment at which the output signal is provided. In other words, the operational amplifier of the buffer circuit buffers the lower one of the first and the second input signal. Consequently, one input signal can be provided by a bandgap circuit, for example, while the other input signal can be provided by a simple and not so precise but quick starting voltage source. The resulting floating reference signal can be employed for controlling transistors operated in a high voltage range at an earlier point in the startup procedure. Thereby temporary overstress of said transistors is avoided.

In a development, the floating reference signal is configured to control at least one transistor, which is coupled to a high voltage supply terminal. A supply voltage on the high voltage supply terminal exceeds said transistor's operating range.

The at least one transistor may be realized as a MOS or as a bipolar transistor. The operating range of e.g. a PMOS transistor is basically defined by its gate source voltage. An exemplary value for such a PMOS transistor amounts to approximately 1.8 V. Said value is determined by the oxide used. An exemplary value for the supply voltage on the high voltage supply terminal lies between 3.3 and 3.6 V. The floating reference signal provided by the proposed buffer circuit can be used to control the at least one PMOS transistor, especially its gate terminal, already during startup even if the supply voltage exceeds this PMOS transistor's operating range.

In a development, the buffer circuit is configured to be operated in a first mode or in a second mode. In the first mode, the first input signal is buffered and provided as the floating reference signal. In the second mode the second input signal is buffered and provided as the floating reference signal.

The buffer circuit starts operating in the first mode, which is directly followed by the second mode.

According to a development, in the first mode the supply voltage is configured to be switched on, the first and the second input signals are configured to start up following the supply voltage. A voltage component of the first input signal is configured, after an initial delay, to obtain a value that lies at least one threshold voltage of the at least one transistor below the supply voltage. Furthermore, in the first mode, a voltage component of the second input signal is configured to track the supply voltage and subsequently decrease to the level of the voltage component of the first input signal.

In the first mode, the supply voltage is switched on and first and second input signals start up with increasing levels of their respective voltage components. The level of the voltage component of the first input signal in the first mode is always lower than the level of the voltage component of the second input signal. The first input signal obtains or adopts or assumes the value which lies at least one threshold voltage of the at least one transistor, e.g. a PMOS transistor, which is controlled by the floating reference signal below the supply voltage. The level of the voltage component of the second input signal rises with the supply voltage and then decreases. As soon as the level of the voltage component of the first input signal is reached in this decrease, the switchover to the second mode takes place.

It is thereby assured that the gate terminal of said at least one PMOS transistor is controlled from the very beginning of operation of the buffer circuit. For example, by using the first input signal as the floating reference signal and providing it to the gate of said PMOS transistor, this PMOS transistor is deliberately switched on in a controlled way.

According to a development in the second mode, the voltage component of the first input signal is configured to obtain a value that lies at least one threshold voltage of the at least one transistor below the supply voltage. Furthermore, in the second mode the voltage component of the second input signal is adjusted to a value that lies below the value of the voltage component of the first input signal in said second mode.

Consequently, in the second mode the level of the voltage component of the second input signal is always lower than the level of the voltage component of the first input signal, such that the second input signal is provided as the floating reference signal by the buffer circuit. In the second mode, the voltage component of the first input signal more or less stays at the level it has reached at the end of the first mode, i.e. one or two or three threshold voltages of the at least one transistor below the supply voltage. The level of the voltage component of the second input signal decreases below the level of the first input signal, for example to a value that lies approximately a maximum gate source voltage of the at least one PMOS transistor below the supply voltage. The buffer circuit continues to be operated in the second mode.

Consequently the proposed buffer circuit provides the floating reference signal such that especially a PMOS transistor can be fully controlled immediately after power-up, even in a high voltage domain.

In a development the first input signal is configured to be provided by a first voltage source. The first voltage source comprises one of at least one other transistor, which is configured as a diode-connected transistor, a pn-diode or a resistor. The second signal is configured to be provided by a second voltage source comprising a bandgap circuit.

The bandgap circuit is realized as known by those skilled in the art. It basically conforms to the bandgap circuits described above in the background section, which are slow to turn on. The bandgap circuit may or may not have an internal so-called startup circuit, as known to the skilled person. The first voltage source is realized in a simple way, for example by providing one or two or even three (depending on the transistors operating range and the supply voltage) diode-connected transistors, e.g. PMOS transistors, or the pn-diode, or the resistor in series to a suitable current source. Each of these realizations provides the first input signal with a level of its voltage component at approximately one or two or even three threshold voltages of the transistor controlled by the floating reference signal. The first input signal is consequently provided as a coarse reference with the floating reference signal, while the second input signal is a precise reference signal. The first input signal is provided at the required level as soon as the supply voltage has reached a level which enables operation of its components. Until the bandgap circuit of the second voltage source has properly started and is able to provide the second input signal at the required level, the coarse reference signal, i.e. the first input signal, is buffered and provided as the floating reference signal for control of one or more downstream connected transistors, e.g. PMOS transistors. It is thereby ensured that even during startup of the bandgap circuit of the second voltage source, a downstream connected transistor remains controlled by using the first input signal in an auxiliary way as the floating reference signal. Due to its simple implementation, the first voltage source starts quicker than the second voltage source. Consequently, merely from the switching on of the suppy voltage, the at least one PMOS transistor can be turned on by control of the floating reference signal without damaging it. Thereby the chicken and egg problem described above is also solved.

According to a development, the operational amplifier comprises a first, a second and a third transistor, a current source, a first, a second and a third current mirror. The first transistor comprises a control terminal which represents the first input of the operational amplifier. The second transistor comprises a control terminal which represents the second input of the operational amplifier. The third transistor comprises a control terminal which represents the third input of the operational amplifier. The current source is connected, on the one hand, to the high voltage supply terminal and, on the other hand, to respective second terminals of the first, the second and the third transistor. The first current mirror has an input terminal which is connected to respective third terminals of the first and the second transistor, and an output terminal which represents the output of the operational amplifier. The second current mirror comprises an input terminal which is connected to a third terminal of the third transistor, and an output terminal. The third current mirror comprises an input terminal which is connected to the output terminal of the second current mirror and an output terminal which is connected to the output of the operational amplifier.

By means of the transistors, the current source and the current mirrors, the buffer circuit is implemented such that the input out of the first and second input which receives the lower input signal turns the involved transistor on more. A current provided by the current source consequently flows to this transistor and is mirrored by the first current mirror or, alternatively, by the second and third current mirrors towards the output. The output is consequently pulled up or pulled down. Due to the negative feedback, i.e. the connection of the output to the third input, the output follows the negative input. By using the second transistor, whose gate terminal represents the second input of the operational amplifier, the current provided by the current source swings to the side which pulls the output low, because either the first input or the second input is lower than the third input.

The first, second and third transistor may each be implemented by a PMOS transistor. The current source may be realized, for example, by another current mirror which can be made up of PMOS transistors.

In a development the first and the second current mirrors each comprise at least two transistors of a same type. The third current mirror comprises at least two transistors of a type complementary to the type of the transistors of the first and second current mirror. In each case, the transistors are connected in a current mirror configuration as known to the skilled person.

In one embodiment, a voltage generating circuit comprises the buffer circuit as described above, a first voltage source and a second voltage source. The first voltage source is configured for providing the first input signal and is coupled to the first input of the operational amplifier of the buffer circuit. The second voltage source is configured for providing the second input signal and is coupled to the second input of the operational amplifier of the buffer circuit.

The first voltage source may be realized by using at least one PMOS transistor configured as a diode-connected transistor, a pn-diode or a resistor in series with a current source as described above. The second voltage source may comprise a bandgap circuit, also as described above.

Consequently the voltage generating circuit is enabled to provide the floating reference signal in the first mode by providing the first input signal generated by the first voltage source and in the second mode as the second input signal generated by the second voltage source. By this, in the first mode right after startup of the supply voltage, the first input signal is provided as the floating reference signal, i.e. as the less precise reference which is derived from the threshold voltage of the e.g. PMOS transistor. As soon as the second voltage source, i.e. the bandgap circuit, has settled and is fully operable, the precise output signal of the bandgap circuit is used as the floating reference signal. This simple solution enables control of the at least one downstream-connected transistor, e.g. a PMOS transistor, in a high-voltage domain even during start up of the bandgap circuit.

The proposed buffer circuit and/or voltage generating circuit each can be applied to or realized by circuits using CMOS or bipolar transistor technology.

In one embodiment a method for providing a floating reference signal comprises the following steps:
- receiving a first input signal,
- receiving a second input signal, and
- providing either the first or the second input signal, such that a lower one of the first and the second input signal is provided as the floating reference signal.

The method may be implemented by the buffer circuit according to one of the embodiments described above.

In a development, the method further comprises the steps of: In a first mode of operation:
- turning on a high voltage supply and ramping up a supply voltage provided by the high voltage supply,
- generating the first and the second input signal using the supply voltage,
- ramping up the first input signal and providing it as the floating reference signal, the first input signal comprising a voltage component with a value that lies at least one threshold voltage below the supply voltage,
- ramping up the second input signal until its voltage component reaches approximately the value of the supply voltage and subsequently ramping down the voltage component of the second input signal to the level of the voltage component of the first input signal,
wherein the threshold voltage represents a threshold voltage of at least one transistor which is controlled by the floating reference signal.

In a development, the method comprises the following steps: In a second mode of operation:
- providing the first input signal with its voltage component having a value that lies at least one threshold voltage below the supply voltage,
- further ramping down the voltage component of the second input signal to a value that lies below the value of the voltage component of the first input signal in the second mode, and
- providing the second input signal as the floating reference signal,
wherein the second mode of operation immediately follows the first mode of operation.

By using the method as proposed, i.e. by using two different input signals for generating the floating reference signal, said reference signal can be used for controlling operation of at least one transistor, e.g. a PMOS transistor, which is implemented in a downstream-connected circuit supplied by a voltage which lies in a range which exceeds said transistor's operating range.

### Brief description of the drawings

The text below explains the proposed solution in detail using exemplary embodiments with reference to the drawings. Components and elements that are functionally identical or have an identical effect bear identical reference numbers. Insofar as parts or components correspond to one another in their function, a description of them will not be repeated in each of the following figures. Therein,
- Figure 1: shows an exemplary embodiment of a voltage generating circuit with a buffer circuit as proposed,
- Figure 2: shows an exemplary embodiment of an operational amplifier as proposed,
- Figure 3: shows an exemplary signal diagram, and
- Figure 4: shows an exemplary embodiment of the buffer circuit as proposed in an application example,
- Figure 5: shows another exemplary embodiment of the buffer circuit as proposed in an application example, and
- Figure 6: shows an exemplary embodiment of a method as proposed.

### Detailed description

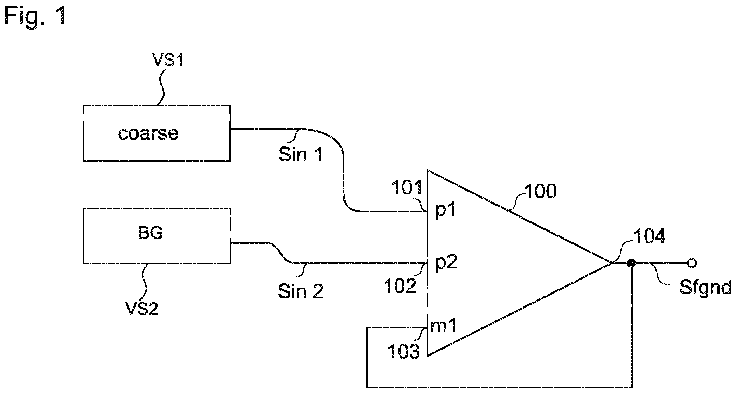

Figure 1 shows an exemplary embodiment of a voltage generating circuit with a buffer circuit as proposed. The buffer circuit comprises an operational amplifier 100 which comprises a first input 101, a second input 102, a third input 103 and an output 104. The first input 101 represents a non-inverting input p1, which is configured to receive a first input signal Sin1. The second input 102 represents a second non-inverting input p2, which is configured to receive a second input signal Sin2. The third input 103 represents an inverting input m1. The first and the second input 101, 102 of the operational amplifier 100 realize the first and the second input of the buffer circuit. The output 104 forms an output of the buffer circuit. The output 104 is connected to the third input 103 which configures the operational amplifier 100 as a voltage follower. The buffer circuit is configured to provide either the first or the second input signal Sin1, Sin2 at its output 104, such that a lower one of the first and the second input signal Sin1, Sin2 is provided as a floating reference signal Sfgnd.

A floating reference is required for high voltage circuit designs which may operate in a range of 3.3 V using for example 1.8 V devices, i.e. CMOS or bipolar transistors, as described above. These devices are stacked between a ground potential and the floating reference in the case of NMOS transistors, and between the floating reference and the supply voltage of about 3.3 V in the case of PMOS transistors. By using the suggested buffer circuit comprising the operational amplifier 100 having two non-inverting inputs p1 and p2, the lower one of the first and the second input signals Sin1, Sin2 is provided as the floating reference signal Sfgnd. This ensures proper startup of the floating reference signal Sfgnd and thereby prevents temporary overstress of devices, especially PMOS transistors, controlled by the floating reference signal Sfgnd.

The depicted voltage generating circuit comprises the buffer circuit as described above and a first voltage source VS1, as well as a second voltage source VS2. The first voltage source VS1 is configured to provide the first input signal Sin1, while the second voltage source VS2 is configured to provide the second input signal Sin2. The first voltage source VS1 is coupled to the first input 101 of the operational amplifier 100. The first voltage source VS1 comprises either at least one PMOS transistor configured as a diode-connected transistor, or a pn-diode or a resistor, each of which are or is connected in series with a current source to a supply voltage, for example a high supply voltage. The second voltage source VS2 is connected to the second input 102 of the operational amplifier 100. The second voltage source VS2 comprises a bandgap circuit as known to those skilled in the art. The second input signal Sin2 is provided by the second voltage source VS2 in a highly accurate way and is immune to variations in supply voltage and/or environmental conditions or process. The first input signal Sin1 provided by the first voltage source VS1 is derived based on the threshold voltage of a PMOS transistor used in this voltage source, for example. The fixed current provided by the current source flows over the at least one diode-connected PMOS transistor to produce the first input signal Sin1. In contrast to the bandgap circuit of the second voltage source VS2 which is slow to start up, the first voltage source VS1 designed as described starts quicker.

The buffer circuit is configured to be operated in a first mode or in a second mode. In the first mode, the first input signal Sin1 is buffered by the operational amplifier 100 and provided as the floating reference signal Sfgnd. In the second mode, the second input signal Sin2 is buffered and provided as the floating reference signal Sfgnd. By this, the first input signal Sin1 is used as an auxiliary reference and provided as the floating reference signal Sfgnd right from the beginning of operation, i.e. power-up, of the buffer circuit in the first mode. As soon as the second voltage source VS2 has fully turned on and the second input signal Sin2 is provided at the desired level, the buffer circuit enters into the second mode and the second input signal Sin2 is provided as the floating reference signal Sfgnd. Therein, the first input signal Sin1 is designed such that during operation, i.e. in the second mode, it is always higher than the second input signal Sin2, such that the first input signal Sin1 is only used in the first mode of operation until the bandgap circuit of the second voltage source VS2 has turned on and the second input signal Sin2 is provided at the desired level.

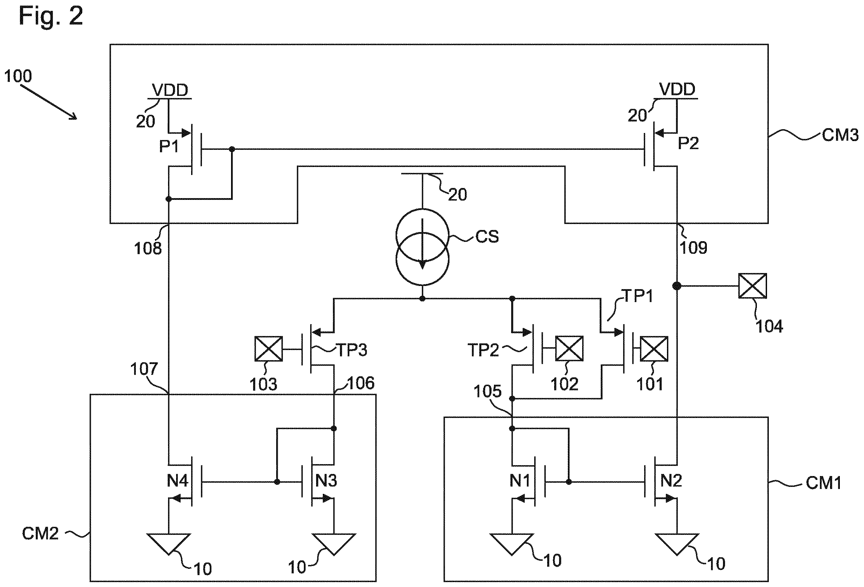

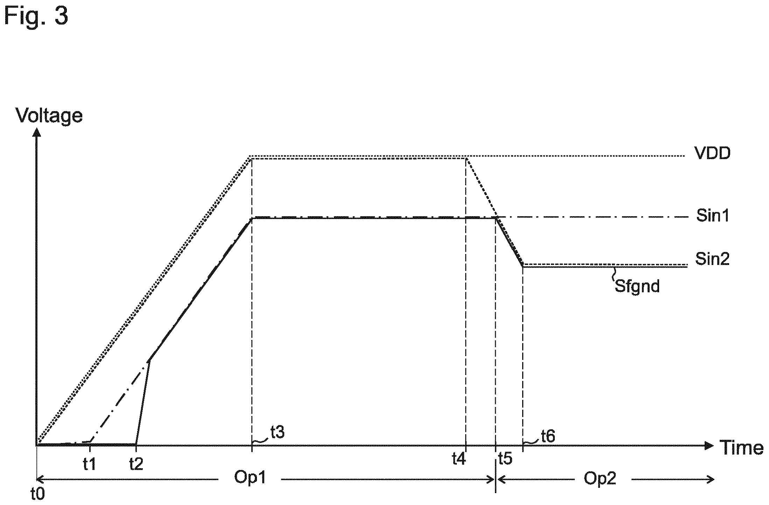

Detailed functioning of the buffer circuit is described further below with reference to Figures 2 and 3.

Figure 2 shows an exemplary embodiment of an operational amplifier as proposed. The operational amplifier 100 here is implemented in CMOS technology and comprises a first PMOS transistor TP1, a second PMOS transistor TP2, a third PMOS transistor TP3, a current source CS, a first current mirror CM1, a second current mirror CM2 and a third current mirror CM3. The current source CS is connected to a high voltage supply terminal 20 which carries a supply voltage VDD. The first PMOS transistor TP1 comprises a control terminal, i.e. a gate terminal, which represents the first input 101. The second PMOS transistor TP2 comprises a gate terminal which represents the second input 102. Respective second terminals, i.e. source terminals, of the first and the second PMOS transistor TP1, TP2 are connected to each other and to the current source CS. Respective third terminals, i.e. drain terminals, of the first and the second PMOS transistors TP1, TP2 are connected to each other and to an input terminal 105 of the first current mirror CM1. The first current mirror CM1 comprises two NMOS transistors N1 and N2 which are coupled in a current mirror configuration between the input 105 of the first current mirror CM1, a reference potential terminal 10 and the output 104, such that a current at the input 105 is mirrored towards the output 104.

The third PMOS transistor TP3 is coupled by its source terminal to the current source CS and to the source terminals of the second and the first PMOS transistor TP2, TP1. A drain terminal of the third PMOS transistor TP3 is coupled to an input terminal 106 of the second current mirror CM2. The second current mirror CM2 comprises two NMOS transistors N3 and N4. The NMOS transistors N3 and N4 are coupled to each other in a current mirror configuration between the input 106, the reference potential terminal 10 and an output 107 of the second current mirror CM2, such that a current at the input 106 is mirrored to the output 107 of the second current mirror CM2. The third current mirror CM3 comprises two PMOS transistors P1, P2 which are coupled in a current mirror configuration between an input 108, the high voltage supply terminal 20 and the output 109 of the third current mirror CM3. The input 108 of the third current mirror CM3 is connected to the output 107 of the second current mirror CM2. The output 109 of the third current mirror CM3 is connected to the output 104 of the operational amplifier 100, such that a current at the input 108 of the third current mirror CM3 is mirrored from transistor P1 via transistor P2 to the output 109 of the third current mirror CM3, respectively the output 104.

In addition to the differential pair of the second and the third PMOS transistor TP2 and TP3, the first PMOS transistor TP1 is added in order to realize a selection of the lower input voltage provided by the first and the second input signal Sin1, Sin2 provided to the gate terminal of the first PMOS transistor TP1 and the gate terminal of the second PMOS transistor TP2, respectively. Whichever of these transistors has the lower gate voltage will be turned on more. Consequently, this transistor controls the source voltage of the differential pair. The common source voltage, i.e., the source voltage of transistors TP1, TP2 and TP3 is then one source gate voltage above the lowest gate voltage. This is due to the fact that if something perturbed this common source node and the voltage on this node increased, the PMOS transistor with the lowest gate voltage would turn on more and pull it back down. If the voltage on said node decreased, all the PMOS transistors would turn off, and this node would charge back up. In short, the common source node of the three PMOS transistors TP1, TP2 and TP3 is one source gate voltage above the lowest gate terminal of these PMOS transistors. A source gate voltage on the other two transistors which have a higher gate voltage at that moment will be less, so they will not be fully on. Consequently, the current provided by the current source CS flows through the PMOS transistor with the lowest gate voltage. Due to the configuration of the operational amplifier 100, realized by the coupling of the output 104 to the third input 103, the output 104 follows either the first or the second input 101, 102. This results in two PMOS transistors, i.e. one of the two p-side PMOS transistors TP1 and TP2 and the n-side PMOS TP3, having a low voltage on their respective gate terminals, which basically splits the current from the current source CS. The input of the remaining PMOS on the p-side is essentially ignored.

In other words, in the case that the first input 101 is lower than the second and the third inputs 102 and 103, current flows from the current source CS via the first PMOS transistor TP1, gets mirrored in the first current mirror CM1 and pulls the output 104 to the level of the first input 101.

This happens during the first mode of operation. If the second input 102 is lower than the first and the third inputs 101 and 103, current from the current source CS flows via the second PMOS transistor TP2, gets mirrored in the first current mirror CM1 and pulls the output 104 down to the level of a voltage component of the second input signal Sin2 at the second input 102. This happens during the second mode of operation.

Figure 3 shows an exemplary signal diagram. In relation to time, the course of the voltage components of the first input signal Sin, the second input signal Sin2, the floating reference signal Sfgnd and the supply voltage VDD as occurring in the circuits of Figure 1 and 2 are depicted, respectively.

At point in time t0 the supply voltage VDD is switched on. First and second input signals Sin1 and Sin2 start ramping up. Due to the slow starting procedure of the bandgap circuit providing the second input signal Sin2, said signal in the first operating mode Op1 follows or tracks the supply voltage VDD. After an initial delay, for example until the supply voltage VDD has a level high enough to turn on the PMOS transistor of the first voltage source, the first input signal Sin1 at point in time t1 also follows the supply voltage VDD with its voltage component adopting a value which is at least one threshold voltage of the at least one PMOS transistor below the supply voltage VDD. The floating reference signal Sfgnd, especially its voltage component, follows the level of the first input signal Sin1. A small delay represented by the difference between t1 and t2 may occur until the floating reference signal Sfgnd tracks the first input signal Sin1. At point in time t3, the supply voltage VDD reaches its final value, for instance 3.3 V. A typical value of the threshold voltage is 0.5 V, for instance. Therefore, at point in time t3 the first input signal Sin1, as well as the floating reference signal Sfgnd have a voltage level of approximately 2.8 V in this example. At point in time t4, which still occurs in the first mode Op1, the bandgap circuit of the second voltage source starts operating which results in a decrease of the voltage level of the second input Sin2. At point in time t5 the voltage level of the second input signal Sin2 crosses the level of the first input signal Sin1, which marks the end of the first mode Op1. From point in time t5 onwards the buffer circuit operates in the second mode Op2 in which the second input signal Sin2 is provided as the floating reference signal Sfgnd. At point in time t6, the bandgap circuit of the second voltage source is fully operable and provides the second input signal Sin2 at the desired voltage level. In an example, the voltage level of the second input signal Sin2 is at about 1.5 V below the supply voltage VDD. In this example the floating reference signal's voltage component is provided with 1.8 V.

The coarse reference signal Sin1 provided by the first voltage source is used and provided as the floating reference signal Sfgnd in the first mode Op1 during startup of the circuit. As soon as the bandgap circuit of the second voltage source has a notable current flow and is able to provide the second input signal Sin2 at a reasonable level, that means from point in time t5 onwards, said second input signal Sin2 is provided as the floating reference signal Sfgnd.

Thereby it is assured that a PMOS transistor whose gate terminal is controlled with the floating reference signal Sfgnd can be turned on already during startup of the circuit without damaging the device.

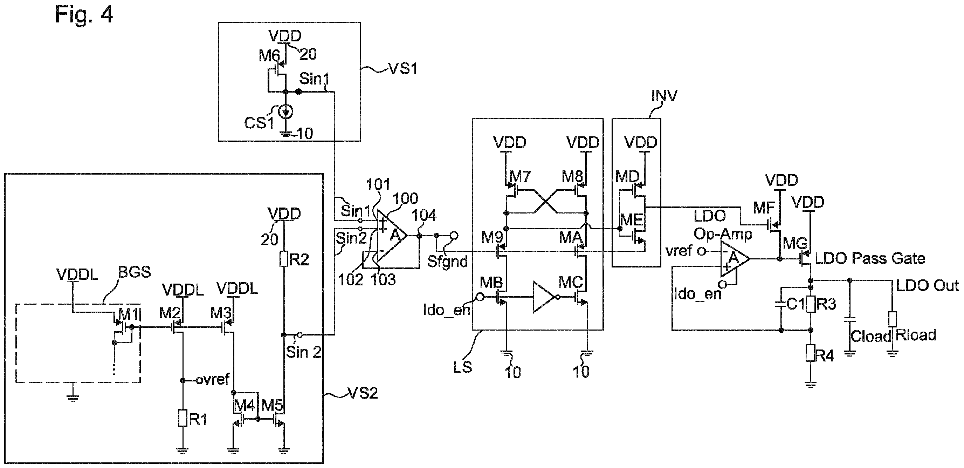

Figure 4 shows an exemplary embodiment of the buffer circuit as proposed in an exemplary application circuit. In this example, the first voltage source VS1 is realized as a serial connection of PMOS transistor M6 and current source CS1 which are coupled between the high voltage supply terminal 20 and ground potential terminal 10. PMOS transistor M6 is configured as a diode-connected transistor. The first signal Sin1 is provided at the connection point between the current source CS1 and the gate and drain terminals of PMOS transistor M6.

The second voltage source VS2 in this example is realized as a bandgap circuit which is configured to generate the second input signal Sin2 as known to the skilled person. The bandgap circuit of the second voltage source VS2 may also have a bootstrap core and bandgap startup circuitry BGS as indicated in Figure 4.

The aim of the circuit in this example is to control the gate terminal of PMOS transistor MF as early as possible from power-up of the supply voltage VDD. For this the floating reference signal Sfgnd which is generated by the buffer circuit 100 as proposed, is passed via a level shifter LS and an inverter INV to the gate terminal of PMOS transistor MF which represents an example of the at least one PMOS transistor. By turning on the at least one PMOS transistor MF, pass gate transistor MG of the downstream connected LDO is turned off in a controlled way as long as said LDO is disabled, even during startup.

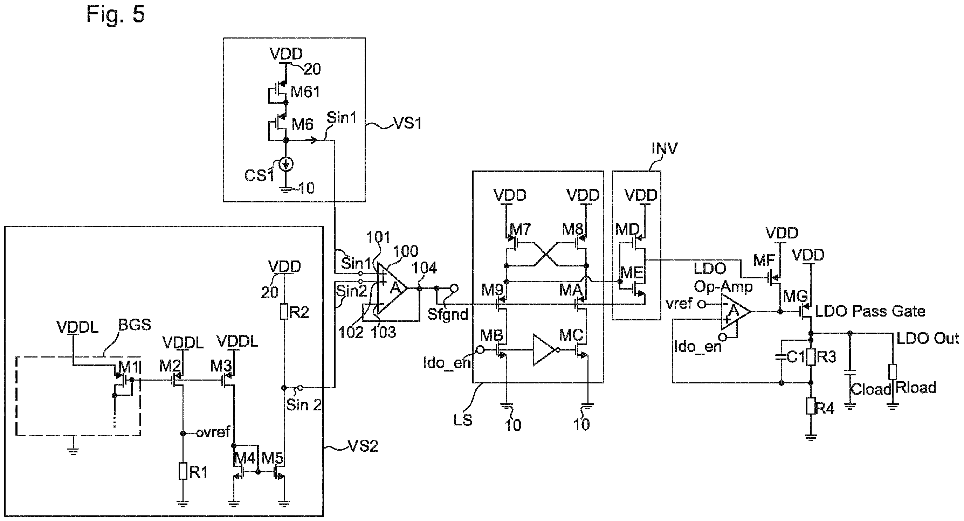

Figure 5 shows another exemplary embodiment of the buffer circuit as proposed in an exemplary application circuit. This embodiment coincides with the embodiment shown in Figure 4 except for the implementation of the first voltage source VS1. In this example, the first voltage source VS1 is realized as a serial connection of PMOS transistor M61, PMOS transistor M6 and current source CS1 which are coupled between the high voltage supply terminal 20 and ground potential terminal 10. Both PMOS transistors M6 and M61 are configured as diode-connected transistors. The first signal Sin1 is provided at the connection point between the current source CS1 and the gate and drain terminals of PMOS transistor M6.

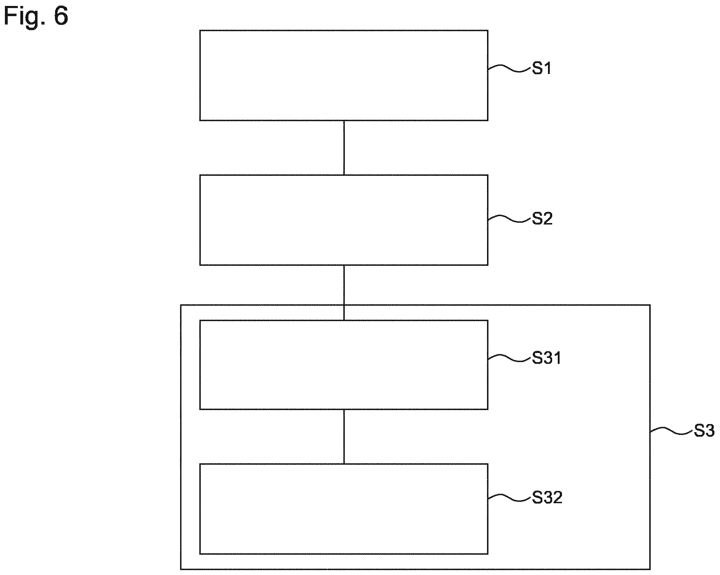

Figure 6 shows an exemplary embodiment of a method as proposed. The method for providing a floating reference signal comprises the following steps:
S1: receiving a first input signal,
S2: receiving a second input signal, and
S3: providing either the first or the second input signal, such that a lower one of the first and the second input signal is provided as the floating reference signal.

The method may be implemented by the buffer circuit according to one of the embodiments described above.

The method may further comprise the steps of:
S31: operating in a first mode of operation, and/or
S32: operating in a second mode of operation.

In the first mode occurring during power up of a supply voltage the first input signal is provided as the floating reference signal, while in the second mode the second input signal is provided as the floating reference signal as detailed above.

In the first mode the following steps are performed:
turning on a high-voltage supply and ramping up a supply voltage provided by the high-voltage supply,
generating the first and the second input signal using the supply voltage,
ramping up the first input signal and providing it as the floating reference signal, the first input signal comprising a voltage component with a value that lies at least one threshold voltage below the supply voltage, wherein the threshold voltage represents a threshold voltage of at least one transistor, which is controlled by the floating reference signal,
ramping up the second input signal until its voltage component reaches approximately the value of the supply voltage and subsequently ramping down the voltage component of the second input signal to the level of the voltage component of the first input signal.

In the second mode the following steps are performed: providing the first input signal with its voltage component having a value that lies at least one threshold voltage below the supply voltage,
further ramping down the voltage component of the second input signal to a value that lies below the value of the voltage component of the first input signal in the second mode, and
providing the second input signal as the floating reference signal,
wherein the second mode of operation immediately follows the first mode of operation.

It will be appreciated that the invention is not limited to the disclosed embodiments and to what has been particularly shown and described hereinabove. Rather, features recited in separate dependent claims or in the description may advantageously be combined. Furthermore, the scope of the invention includes those variations and modifications which will be apparent to those skilled in the art and fall within the scope of the appended claims. The term "comprising" used in the claims or in the description does not exclude other elements or steps of a corresponding feature or procedure. In the case that the terms "a" or "an" are used in conjunction with features, they do not exclude a plurality of such features. Moreover, any reference signs in the claims should not be construed as limiting the scope.

### Reference list

- Sin1, Sin2, Sfgnd: signal
- VS1, VS2: voltage source
- CS, CS1: current source
- 10, 20: terminal
- 100: operational amplifier
- 101, 102, 103, 104, 105, 106, 107: terminal
- 108, 109: terminal
- TP1, TP2, TP3: transistor
- N1, N2, N3, N4: transistor
- P1, P2, M6, M61, MF, MG: transistor
- LS: level shifter
- INV: inverter
- BGS: startup circuitry
- CM1, CM2, CM3: current mirror
- t0, t1, t2, t3, t4, t5, t6: point in time
- Op1, Op2: mode
- S1, S2, S3, S31, S32: method step
- VDD: supply voltage

## Claims

1. A buffer circuit for providing a floating reference signal, the buffer circuit comprising an operational amplifier (100) comprising
- a first input (101) representing a non-inverting input, which is configured to receive a first input signal (Sin1),
- a second input (102) representing another non-inverting input, which is configured to receive a second input signal (Sin2),
- a third input (103) representing an inverting input, and
- an output (104) forming an output of the buffer circuit,
- wherein the operational amplifier (100) is configured as a voltage follower in that its output (104) is connected to its third input (103),
- wherein the buffer circuit is configured to provide either the first or the second input signal (Sin1, Sin2) at its output (104), such that a lower one of the first and the second input signal (Sin1, Sin2) is provided as the floating reference signal (Sfgnd).

2. The buffer circuit according to claim 1,
wherein the floating reference signal (Sfgnd) is configured to control at least one transistor (MF), which is coupled to a high-voltage supply terminal (20), wherein a supply voltage (VDD) on the high-voltage supply terminal (20) exceeds said transistor's operating range.

3. The buffer circuit according to claim 2,
wherein the buffer circuit is configured to be operated in a first mode of operation (Op1) or in a second mode of operation (Op2), wherein in the first mode the first input signal (Sin1) is buffered and provided as the floating reference signal (Sfgnd) and wherein in the second mode the second input signal (Sin2) is buffered and provided as the floating reference signal (Sfgnd).

4. The buffer circuit according to claim 3,
wherein in the first mode (Op1):
the supply voltage (VDD) is configured to be switched on, the first and the second input signals (Sin1, Sin2) are configured to start up following the supply voltage (VDD), wherein a voltage component of the first input signal (Sin1) is configured to after an initial delay obtain a value that lies at least one threshold voltage of the at least one transistor (MF) below the supply voltage, and wherein a voltage component of the second input signal (Sin2) is configured to track the supply voltage and subsequently decrease to the level of the voltage component of the first input signal (Sin1).

5. The buffer circuit according to claim 3 or 4,
wherein in the second mode (Op2):
the voltage component of first input signal (Sin1) is configured to obtain a value that lies at least one threshold voltage of the at least one transistor (MF) below the supply voltage, and
wherein the voltage component of the second input signal (Sin2) is adjusted to a value that lies below the value of the voltage component of the first input signal (Sin1) in the second mode.

6. The buffer circuit according to any of claims 1 to 5,
wherein the first input signal (Sin1) is configured to be provided by a first voltage source (VS1) comprising one of at least one other transistor, which is configured as a diode-connected transistor, a pn diode or a resistor,
wherein the second signal (Sin2) is configured to be provided by a second voltage source (VS2) comprising a bandgap circuit.

7. The buffer circuit according to any of claims 1 to 6,
wherein the operational amplifier (100) comprises
a first transistor (TP1) comprising a control terminal, which represents the first input (101) of the operational amplifier (100),
a second transistor (TP2) comprising a control terminal, which represents the second input (102) of the operational amplifier (100),
a third transistor (TP3) comprising a control terminal, which represents the third input (103) of the operational amplifier (100),
a current source (CS) which is connected between the high-voltage supply terminal (20) and respective second terminals of the first, the second and the third transistor (TP1, TP2, TP3),
a first current mirror (CM1) comprising an input terminal (105), which is connected to respective third terminals of the first and the second transistor (TP1, TP2), and an output terminal representing the output (104) of the operational amplifier (100), and
a second current mirror (CM2) comprising an input terminal (106), which is connected to a third terminal of the third transistor (TP3), and an output terminal (107),
a third current mirror (CM3) comprising an input terminal (108), which is connected to the output terminal (107) of the second current mirror (CM2), and an output terminal (109), which is connected to the output (104) of the operational amplifier (100).

8. The buffer circuit according to claim 7,
wherein the first and the second current mirror (CM1, CM2) each comprise at least two transistors (N1, N2, N3, N4) of a same type, and
wherein the third current mirror (CM3) comprises at least two transistors (P1, P2) of a type complementary to the type of the transistors of the first and second current mirror.

9. A voltage generating circuit comprising
the buffer circuit according to any of claims 1 to 8,
a first voltage source (VS1) for providing the first input signal (Sin1), the first voltage source (VS1) being coupled to the first input (101) of the operational amplifier (100) of the buffer circuit, and
a second voltage source (VS2) for providing the second input signal (Sin2), the second voltage source (VS2) being coupled to the second input (102) of the operational amplifier (100) of the buffer circuit.

10. A method for providing a floating reference signal comprising the following steps:
receiving (S1) a first input signal (Sin1),
receiving (S2) a second input signal (Sin2), and
providing (S3) either the first or the second input signal (Sin1, Sin2), such that a lower one of the first and the second input signal (Sin1, Sin2) is provided as the floating reference signal (Sfgnd).

11. The method according to claim 10,
further comprising
in a first mode of operation (S31):
turning on a high-voltage supply and ramping up a supply voltage (VDD) provided by the high-voltage supply,
generating the first and the second input signal (Sin1, Sin2) using the supply voltage,
ramping up the first input signal (Sin1) and providing it as the floating reference signal (Sfgnd), the first input signal (Sin1) comprising a voltage component with a value that lies at least one threshold voltage below the supply voltage,
wherein the threshold voltage represents a threshold voltage of at least one transistor (MF), which is controlled by the floating reference signal (Sfgnd),
ramping up the second input signal (Sin2) until its voltage component reaches approximately the value of the supply voltage and subsequently ramping down the voltage component of the second input signal (Sin2) to the level of the voltage component of the first input signal (Sin1).

12. The method according to claim 11,
further comprising
in a second mode of operation (S32):
providing the first input signal (Sin1) with its voltage component having a value that lies at least one threshold voltage below the supply voltage,
further ramping down the voltage component of the second input signal (Sin2) to a value that lies below the value of the voltage component of the first input signal (Sin1) in the second mode, and
providing the second input signal (Sin2) as the floating reference signal (Sfgnd),
wherein the second mode of operation immediately follows the first mode of operation.
